# EUROPEAN PATENT APPLICATION

(11) **EP 0 952 613 A1**
(43) Date of publication of application: **27.10.1999**
(21) Application number: 99107333.9
(22) Date of filing: 20.04.1999
(51) Int. Cl.: H01L 23/495, H01L 25/065

(54) **A multiple device integrated circuit package having feed-through connections**

(30) Priority: 20.04.1998 US 63025
(71) Applicant: MICROCHIP TECHNOLOGY INC., Chandler, AZ 85224-6199 (US)
(72) Inventor: Schroeder, Eric, Phoenix, Arizona 85044 (US); Rogers, Clark, Phoenix, Arizona 85044 (US); Hull, Richard L., Chandler, Arizona 85248 (US)
(74) Representative: Frohwitter, Bernhard, Dipl.-Ing.

(57) **Abstract**

A multiple device integrated circuit package having feed-through connections. A first device is mounted within an integrated circuit package and is coupled to a plurality of pins of the integrated circuit package. A second device is mounted within the integrated circuit package and has at least one feed-through connector. The feed-through connector is used for coupling the first device to the second device for allowing the first device to be coupled to one of the plurality of pins via the second device.

## Description

### RELATED APPLICATIONS

This application is related to the patent application entitled "AN INTEGRATED CIRCUIT PACKAGE HAVING INTERCHIP BONDING AND METHOD THEREFOR", Serial Number 09/036,170, filed March 6, 1998, in the name of Drehobl et al., and assigned to the same assignee as this Application. The disclosure of the above referenced Application is hereby incorporated by reference into this application.

### BACKGROUND OF THE INVENTION

### Field of the Invention:

This invention relates generally to integrated circuits and, more specifically, to an integrated circuit package having at least two devices mounted therein wherein at least one of the devices has feed-through connections for allowing a second device to be coupled to the lead frame of the integrated circuit package.

### Description of the Prior Art:

Processors, such as a microcontroller, often contain features to perform certain tasks which are desired for certain systems. Some examples might be power-on-reset or brown-out detect. These features are often integrated onto a single device, but on some occasions, an external device can be used as a peripheral to the microcontroller. In some cases, system constraints can make a multiple device system impractical, and a feature would better suit a design if it were contained in the same package as the microcontroller.

If multiple functions are to be added to a microcontroller and offered in the same integrated circuit package, it is desirable to have the same pin configuration as the original microcontroller. One way to accomplish this would be to add the feature to the package device so that the peripheral feature would be contained on the same substrate as the microcontroller. When the feature desired is of the same process technology of the existing microcontroller, this methodology is an excellent solution. However, when the feature desired is of a different process technology, this causes an increase in processing and circuit complexity.

Another method of adding features to a microcontroller would be to have multiple devices in one package as disclosed in the patent application entitled "AN INTEGRATED CIRCUIT PACKAGE HAVING INTERCHIP BONDING AND METHOD THEREFOR," Serial Number 09/036,170, filed March 6, 1998, in the name of Drehobl et al., assigned to the same assignee as this Application and incorporated by reference into this application. However, since more than one device is in a package, the bonding of the leadframe can be a difficult task.

One way to get around the problem is to use a customized leadframe and die paddle configuration. The customized leadframe and die paddle configuration would have lead fingers routed out into the package to allow for easier bonding for each device in the package. With this technique, the inter-die bonds are accessible at the external package pins. This creates a problem since having these bonds available at the external pins can result in data security problems in certain situations. Furthermore, customized leadframe and die paddle configurations are expensive to implement. Thus, it is desirable to have multiple devices in one package which uses a standardized leadframe and die paddle configuration as disclosed in the patent application entitled "AN INTEGRATED CIRCUIT PACKAGE HAVING INTERCHIP BONDING AND METHOD THEREFOR," Serial Number 09/036,170, filed March 6, 1998, in the name of Drehobl et al., assigned to the same assignee as this Application and incorporated by reference into this application. Having two devices in the same package will cause the first device (the one to which functionality is to be added) to be at a greater distance from one end of the package. Since it is desirable to bond to the same lead fingers, bond wire lengths and bond angles become problematic. Furthermore, stretching the bond wire across the second device also becomes a problem.

A further method is disclosed in U.S. Patent 5,381,039 entitled, "HERMETIC SEMICONDUCTOR DEVICE HAVING JUMPER LEADS," issued on January 10, 1995 to Paul David Morrison. This patent discloses the use jumper leads on a ceramic base so that multiple devices may be interconnected and bonded to a leadframe. However, the problem with this method is that ceramic packages are expensive to use and implement.

Therefore a need existed to provide an improved integrated circuit package. The improved integrated circuit package must increase the functionality of a device in the package by allowing multiple devices to be mounted in the package while maintaining pin compatibility. The improved integrated circuit package must further maintain pin compatibility while not requiring extreme bond wire lengths and bond angles. The improved integrated circuit package must maintain pin compatibility while not stretching the bond wire across the second device. The improved integrated circuit package must be inexpensive to implement. The improved integrated circuit package must allow multiple devices to be mounted in the package while maintaining pin compatibility and not require extreme bond wire lengths and bond angles while eliminating high-cost custom and ceramic packages.

### SUMMARY OF THE INVENTION

In accordance with one embodiment of the present invention, it is an object of the present invention to provide an improved integrated circuit package.

It is another object of the present invention to provide an improved integrated package that increases the functionality of a device in the package by allowing multiple devices to be mounted in the package while maintaining pin compatibility.

It is still another object of the present invention to provided an improved integrated circuit package that maintains pin compatibility while not requiring extreme bond wire lengths and bond angles.

It is yet another object of the present invention to provide an improved integrated circuit package that maintains pin compatibility while not stretching the bond wire across a second device.

It is still a further object of the present invention to provide an improved integrated circuit package that is inexpensive to implement and which eliminates high-cost custom and ceramic packages. The improved inexpensive integrated circuit package must increase the functionality of a device in the package by allowing multiple devices to be mounted in the package while maintaining pin compatibility and must further not require extreme bond wire lengths and bond angles.

### BRIEF DESCRIPTION OF THE PREFERRED EMBODIMENTS

In accordance with one embodiment of the present invention, a multiple device integrated circuit package having feed-through connections is disclosed. The integrated circuit package has a first device mounted within the integrated circuit package wherein the first device is coupled to a plurality of pins of the integrated circuit package. A second device is mounted within the integrated circuit package and has at least one feed-through connector. The feed-through connector is used for coupling the first device to the second device for allowing the first device to be coupled to one of the plurality of pins via the second device.

The foregoing and other objects, features, and advantages of the invention will be apparent from the following, more particular, description of the preferred embodiments of the invention, as illustrated in the accompanying drawings.

### BRIEF DESCRIPTION OF THE DRAWINGS

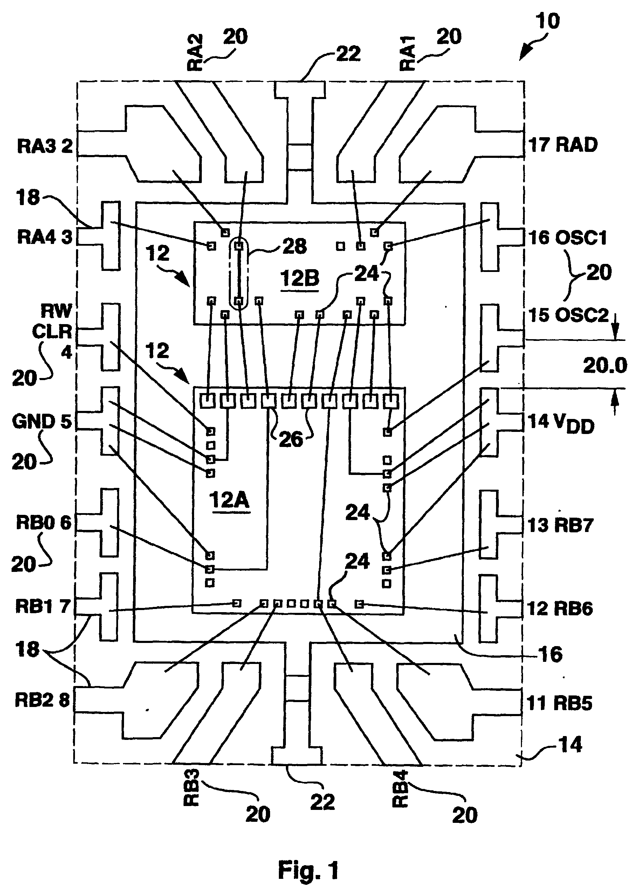

Figure 1 is a simplified block diagram of the improved integrated circuit package having feed-through connectors.

### DETAILED DESCRIPTION OF THE PREFERRED EMBODIMENTS

Referring to Figure 1, an improved integrated circuit package 10 (hereinafter IC package 10) is shown. The IC package 10 allows for a plurality of different devices 12 to be mounted on a leadframe 14 die paddle 16 configuration while maintaining pin compatibility and not requiring extreme bond wire lengths and bond angles or by stretching the bond wire across the second device 12B. The IC package 10 accomplishes this by having the first device 12A being coupled to one of the plurality of pins 20 via a second device 12B through a feed-through connector 28 located on the second device 12B.

The IC package 10 uses a die paddle 16. Preferably, the die paddle 10 is a standard size die paddle 16 and not a custom die paddle thereby reducing the cost of the IC package 10. The die paddle 16 is used for mounting the plurality of different devices 12. Each of the devices 12 are individually mounted on the die paddle 16 using standard assembly operation procedures. In the embodiment depicted in Figure 1, only two devices 12 (a first device 12A and a second device 12B) are shown. However, this should not be seen as a limitation of the scope of the patent. Additional devices 12 may be added to the die paddle 16. The only limitation is the available space on the die paddle 16.

Each device 12 within the IC package 10 is generally coupled to at least one lead finger 18. Each lead finger 18 allows the respective device 12 coupled thereto to have one or more connections to signals external to the IC package 10. Each lead finger 18 forms one of more pins 20 for the IC package 10. The pins 20 are used to provide signals external to the IC package 10 to the devices 12. Some examples of the functionality of the pins 20 include, but are not limited to, power supply, ground, oscillator, input only, input/output, etc.

A leadframe 14 is coupled to the die paddle 16 and to the lead fingers 18. The die paddle 16 is coupled to the leadframe 14 through tie bars 22. The leadframe 14 is used to support the die paddle 16 and the plurality of lead fingers 18.

Each device 12 has one or more die pads 24. Each die pad 24 is a metalized area on the device 12 which allows the device 12 to make connections external to the device 12. The die pads 24 are thus used to allow each device 12 to send and receive signals to and from the device 12. The die pads 24 are generally connected to individual lead fingers 18. Connections are made between each die pad 24 and a respective lead finger 18 through a standard wirebonding process which is known to those skilled in the art. The wirebonding connections between a respective lead finger 18 and a die pad 24 allows signals such as power, clock and communication, which are external to the IC package 10, to be sent to a respective device 12. The external signals are generally coupled to a respective pin 20 of the IC package 10.

The first device 12A also has a plurality of connector die pads 26. Each connector die pad 26 is internally coupled to a die pad 24 of the first device 12A. Each connector die pad 26 is further coupled through a wirebonding process to a die pad 24 of the second device 12B. The interconnection between the connector die pads 26 of the first device 12A and the die pads 24 of the second device 12B allows for interdevice communication. Thus, the first device 12A may communicate and control (i.e., power up or power down) the second device 12B through the wirebonding connections between the connector die pads 26 of the first device 12A and the die pads 24 of the second device.

In the preferred embodiment of the present invention, the first device 12 is generally a processor such as a microprocessor, a microcontroller, or a digital signal processor. The second device 12B is generally some device which will add functionality to the processor such as a memory device like an Electrical Erasable Programmable Read Only Memory (EEPROM), a brown-out circuit, or the like. The IC package 10 will allow for the flexibility and versatility of combining multiple functions and solutions of separate devices into one standard IC package without requiring multiple IC packages for each device. The IC package 10 will allow for the flexibility of combining additional functionality to a standard processor without: 1) a redesign of the processor, 2) redesign of the peripheral device, 3) the necessity of using two or more packages for the same functionality, 4) the necessity of redesigning a custom leadframe to accommodate a plurality of devices in one IC package, 5) utilizing a more complex process to integrate multiple functions onto a single substrate, or 6) requiring the use of a printed circuit board (PCB). The IC package 10 will also allow one to add different devices from different wafer fabrication technologies together into a single IC package. It should be noted that other devices besides a processor and a memory device may be used, The disclosure of a processor and a memory device are just used as examples.

As stated above, in the preferred embodiment of the present invention, the second device 12B is used to increase the functionality of the first device 12A. In order to maintaining pin compatibility while not requiring extreme bond wire lengths, bond wire angles, or stretching the bond wire across the second device 12B, the second device 12B has one or more feed-through connectors 28. The feed-through connectors 28 are placed on the substrate of the second device 12B to aid in bonding from the first device 12A, across the second device 12B, to the lead frame 14/lead finger 18 of the integrated circuit package 10.

Each of the feed-through connectors 28 consists of a bonding pad 26 on one side of the device 12 with an electrical conductive line stretching across the device 12 where it is coupled to a second bonding pad 26. The feed-through connectors 28 allow for the first device 12A to bond to one of the end pads of the feed-through connector 28. The feed-through connector 28 then allows the ability to bond from the other end of the feed-through connector 28 to the leadframe 14/lead finger 18 of the integrated circuit package 10. Thus, an electrical connection from the leadframe 14/lead finger 16 to the first device 12A is accomplished via the second device 12B.

The feed-through connectors 28 eliminate the need for high-cost custom leadframe and die paddle configurations with patterned cavities. The feed-through connectors 28 eliminate lengthy bond wires, creates correct wire bond angles, and eliminates bond wires having to cross packages die. With these problems eliminated, the ability to deliver low cost processors with added peripheral features (i.e., increase functionality) is accomplished by allowing multiple devices to be mounted in a single integrated package while maintaining pin compatibility.

While the invention has been particularly shown and described with reference to preferred embodiments thereof, it will be understood by those skilled in the art that the foregoing and other changes in form, and details may be made therein without departing from the spirit and scope of the invention.

## Claims

1. A multiple device integrated circuit package having feed-through connections comprising, in combination:
a first device mounted within said integrated circuit package and coupled to a plurality of pins of said integrated circuit package; and
a second device mounted within said integrated circuit package and having at least one feed-through connector for coupling said first device to said second device for allowing said first device to be coupled to one of said plurality of pins via said second device.

2. A multiple device integrated circuit package in accordance with Claim 1 wherein said second device has a plurality of feed-through connectors.

3. A multiple device integrated circuit package in accordance with Claim 1 wherein said feed-through connector comprises:
a first feed-through die pad coupled to said second device; and
a second feed-through die pad coupled to said second device wherein said first die pad and said second die pad are coupled together.

4. A multiple device integrated circuit package in accordance with Claim 3 further comprising an electrical conductive line for coupling said first feed-through die pad to said second feed-through die pad.

5. A multiple device integrated circuit package in accordance with Claim 1 wherein said second device is further coupled to said first device for allowing said first device and said second device to communicate with one another.

6. A multiple device integrated circuit package in accordance with Claim 1 wherein said first device is coupled to said second device through wirebonding.

7. A multiple device integrated circuit package in accordance with Claim 1 wherein said second device is coupled to said first device for allowing said first device to control operation of said second device.

8. A multiple device integrated circuit package in accordance with Claim 1 wherein said integrated circuit package further comprises:
a die paddle for mounting said first device and said second device;
a plurality of lead fingers coupled to said first device and to said second device for allowing said first device and said second device to have connections external of said integrated circuit package; and
lead frame coupled to said die paddle and said plurality of lead fingers for supporting said die paddle and said plurality of lead fingers.

9. A multiple device integrated circuit package in accordance with Claim 8 wherein said die paddle has a pair of tie bars for coupling said die paddle to said lead frame.

10. A multiple device integrated circuit package in accordance with Claim 9 wherein said first device and said second device each have a plurality of die pads for allowing said first device and said second device to be connected to individual lead fingers.

11. A multiple device integrated circuit package in accordance with Claim 9 wherein said first device has a plurality of connector die pads wherein each connector die pad is coupled to an individual die pad of said first device and each connector die pad is further coupled to one of an individual die pad of said second device or said at least one feed-through connector.

12. A multiple device integrated circuit package in accordance with Claim 1 wherein said first device is a processor.

13. A multiple device integrated circuit package in accordance with Claim 1 wherein said second device is a memory device.

14. A multiple device integrated circuit package in accordance with Claim 1 wherein said memory device is an Electrical Erasable Programmable Read Only Memory (EEPROM).

15. A multiple device integrated circuit package in accordance with Claim 1 wherein said first device and said second device are separated by a distance of at least 20 mils.

16. A multiple device integrated circuit package having feed-through connections comprising, in combination:
a first device mounted within said integrated circuit package and coupled to a plurality of pins of said integrated circuit package;
a second device mounted within said integrated circuit package and having at least one feed-through connector for coupling said first device to said second device for allowing said first device to be coupled to one of said plurality of pins via said second device, said at least one feed-through connector comprising:
a first feed-through die pad coupled to said second device; and
a second feed-through die pad coupled to said second device wherein said first die pad and said second die pad are coupled together;
a die paddle for mounting said first device and said second device;
a plurality of lead fingers coupled to said first device and to said second device for allowing said first device and said second device to have connections external of said integrated circuit package;
lead frame coupled to said die paddle and said plurality of lead fingers for supporting said die paddle and said plurality of lead fingers;
tie bars for coupling said die paddle to said lead frame;
wherein said first device and said second device each have a plurality of die pads for allowing said first device and said second device to be connected to individual lead fingers;
wherein said first device has a plurality of connector die pads wherein each connector die pad is coupled to an individual die pad of said first device and each connector die pad is further coupled to one of an individual die pad of said second device or said at least one feed-through connector.

17. A multiple device integrated circuit package in accordance with Claim 16 further comprising an electrical conductive line for coupling said first feed-through die pad to said second feed-through die pad.

18. A multiple device integrated circuit package in accordance with Claim 16 wherein said second device is further coupled to said first device for allowing said first device and said second device to communicate with one another.

19. A multiple device integrated circuit package in accordance with Claim 16 wherein said second device is coupled to said first device for allowing said first device to control operation of said second device.

20. A multiple device integrated circuit package in accordance with Claim 16 wherein said first device and said second device are separated by a distance of at least 20 mils.
